# EUROPEAN PATENT APPLICATION

(11) **EP 4 137 811 A1**
(43) Date of publication of application: **22.02.2023**
(21) Application number: 22177489.6
(22) Date of filing: 25.08.2016
(51) Int. Cl.: G01N 27/414

(54) **DEEP MICROWELL DESIGN AND METHOD OF MAKING THE SAME**

(30) Priority: 25.08.2015 US 201562209370 P
(62) Divisional of application: 16759949.7
(71) Applicant: Life Technologies Corporation, Carlsbad, CA 92008 (US)
(72) Inventor: BUSTILLO, James, Carlsbad, 92008 (US); GRAY, Jeremy, Carlsbad, 92008 (US); OWENS, Jordan, Carlsbad, 92008 (US)
(74) Representative: Ziermann, Oliver

(57) **Abstract**

An apparatus includes a substrate; a gate structure disposed over the substrate and having an upper surface; a well structure disposed over the substrate and defining a well over the upper surface of the gate structure; a conductive layer disposed on the upper surface of the gate structure and at least partially extending along a wall of the well in the well structure; and a dielectric structure disposed over the well structure and defining an opening to the well.

## Description

### CROSS-REFERENCE TO RELATED APPLICATION(S)

This application claims benefit of U.S. Provisional Application No. 62/209,370, filed August 25, 2015, which is incorporated herein by reference in its entirety.

### FIELD OF THE INVENTION

This disclosure, in general, relates to sensors for chemical or biological analysis, and to methods for manufacturing such sensors.

### BACKGROUND

A variety of types of chemical devices have been used in the detection of chemical processes. One type is a chemically-sensitive field effect transistor (chemFET). A chemFET includes a source and a drain separated by a channel region, and a chemically sensitive area coupled to the channel region. The operation of the chemFET is based on the modulation of channel conductance, caused by changes in charge at the sensitive area due to a chemical reaction occurring nearby. The modulation of the channel conductance changes the threshold voltage of the chemFET, which can be measured to detect or determine characteristics of the chemical reaction. The threshold voltage can, for example, be measured by applying appropriate bias voltages to the source and drain, and measuring a resulting current flowing through the chemFET. As another example, the threshold voltage can be measured by driving a known current through the chemFET, and measuring a resulting voltage at the source or drain.

An ion-sensitive field effect transistor (ISFET) is a type of chemFET that includes an ion-sensitive layer at the sensitive area. The presence of ions in an analyte solution alters the surface potential at the interface between the ion-sensitive layer and the analyte solution, due to the protonation or deprotonation of surface charge groups caused by the ions present in the analyte solution. The change in surface potential at the sensitive area of the ISFET affects the threshold voltage of the device, which can be measured to indicate the presence or concentration of ions within the solution. Arrays of ISFETs can be used for monitoring chemical reactions, such as DNA sequencing reactions, based on the detection of ions present, generated, or used during the reactions. See, for example, U.S. Patent No. 7,948,015 to Rothberg et al., which is incorporated by reference herein in its entirety. More generally, large arrays of chemFETs or other types of chemical devices can be employed to detect and measure static or dynamic amounts or concentrations of a variety of analytes (e.g. hydrogen ions, other ions, compounds, etc.) in a variety of processes. The processes can, for example, be biological or chemical reactions, cell or tissue cultures or monitoring neural activity, nucleic acid sequencing, etc.

An issue that arises in the operation of large scale chemical device arrays is the susceptibility of the sensor output signals to noise. Specifically, the noise affects the accuracy of the downstream signal processing used to determine the characteristics of the chemical or biological process being detected by the sensors. It is therefore desirable to provide devices including low noise chemical devices, and methods for manufacturing such devices.

### BRIEF DESCRIPTION OF THE DRAWINGS

FIG. 1 illustrates a block diagram of components of a system for nucleic acid sequencing according to an exemplary embodiment.
FIG. 2 illustrates a cross-sectional view of a portion of the integrated circuit device and flow cell according to an exemplary embodiment.
FIG. 3 illustrates cross-sectional of representative chemical devices and corresponding reaction regions according to an exemplary embodiment.
FIGS. 4 to 25 illustrate stages in a manufacturing process for forming an array of chemical devices and corresponding well structures according to an exemplary embodiment.
FIGS. 26-30 include images of work pieces at various stages in the manufacturing process.

### DETAILED DESCRIPTION

Chemical devices are described that include low noise chemical devices, such as chemically-sensitive field effect transistors (chemFETs), for detecting chemical reactions within overlying, operationally associated reaction regions. A sensor of a chemical device can comprise a plurality of floating gate conductors with a sensing layer deposited on an uppermost floating conductor of the plurality of floating gate conductors. Applicant found that adding an additional layer above uppermost floating conductor of the plurality of floating gate conductors that is dedicated to sensing has advantages that overcome the technical challenges and cost of the additional layer. For example, Applicant have found that advantages in the chemical devices described herein include providing enhanced lithographic process margin; (for example, prevent misalign of openings or burnout); and providing larger openings in the dielectric than would be possible were the sensing area directly on top of the uppermost floating gate conductor (for example, larger openings can accommodate more signal). Moreover, well-to-well diffusion of products produces colonies (duplicates) and increase polyclonality. Applicant found that deeper wells can mitigate well-to-well diffusion and allow more time for target DNA to immobilize and amplify.

Exemplary chemical devices described herein have sensing surface areas which can comprise a dedicated layer for sensing. In embodiments described herein, a conductive element overlies and is in communication with an uppermost floating gate conductor. Because the uppermost floating gate conductor can be used to provide array lines (e.g. word lines, bit lines, etc.) and bus lines for accessing/powering the chemical devices, the uppermost floating gate conductor should be a suitable material or mixture of materials and of sufficient thickness therefor. Since the conductive element is within a different layer on the substrate of the chemical device, the conductive element can function as a dedicated sensing surface area independent of the material and thickness of the uppermost floating gate structure. As a result, low noise chemical devices can be provided in a high density array, such that the characteristics of reactions can be accurately detected. Additionally, the uppermost floating gate conductor may not be pushed to process limits; while adjacent floating gate conductors should have a thickness (i.e. for low resistivity) suitable for carrying high currents, the space between adjacent floating gate conductors may not be the minimum space allowed by process design rules. The material(s) used for the uppermost floating gate conductor can be selected based on their suitability to carry high currents. Providing the conductive element overlying and in communication with the uppermost floating gate conductor provides greater freedom in choice of material for the conductive element since the conductive element is on a different layer than the uppermost floating gate conductor. The conductive element disposed over the uppermost floating gate conductor can at least partially extend along the well wall. For example, the conductive element can extend at least 20% along the wall surface, such as at least 30% along the wall surface, at least 40% along the wall surface, at least 50%, at least 60%, at least 70%, at least 80%, at least 90%, at least 95%, or even 100% along the wall surface. The upper surface of the well wall structure can be free of the conductive element. In an embodiment, the conductive element can cover the entire bottom of the well such that no part of the uppermost floating gate conductor is exposed to the well opening. In an embodiment, the conductive element is disposed along the bottom of the well but does not fully extend between the sidewalls, such that the bottom of the well is only partially covered by the conductive element.

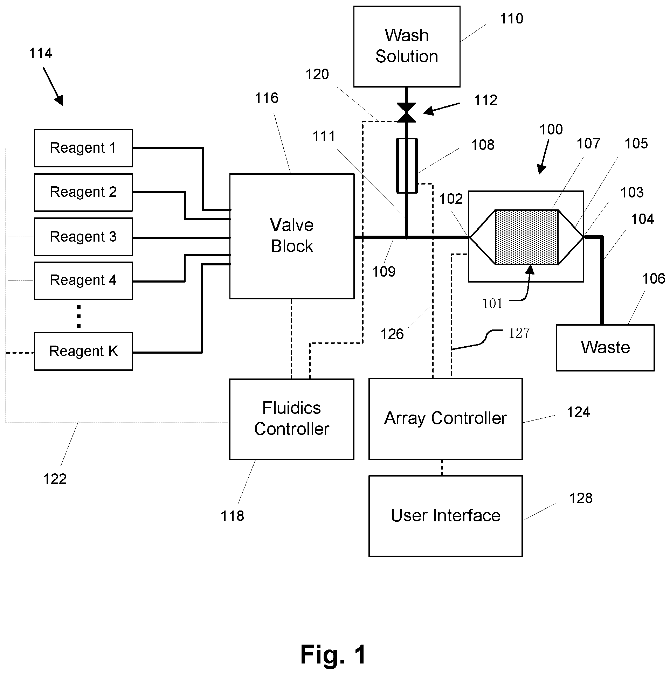

FIG. 1 illustrates a block diagram of components of a system for nucleic acid sequencing according to an exemplary embodiment. The components include flow cell 101 on integrated circuit device 100, reference electrode 108, plurality of reagents 114 for sequencing, valve block 116, wash solution 110, valve 112, fluidics controller 118, lines 120/122/126, passages 104/109/111, waste container 106, array controller 124, and a user interface 128. Integrated circuit device 100 includes a microwell array 107 overlying a sensor array that includes chemical devices as described herein. Flow cell 101 includes an inlet 102, an outlet 103, and flow chamber 105 defining a flow path of reagents over microwell array 107. Reference electrode 108 can be of any suitable type or shape, including a concentric cylinder with a fluid passage or a wire inserted into a lumen of passage 111. Reagents 114 can be driven through the fluid pathways, valves, and flow cell 101 by pumps, gas pressure, or other suitable methods, and can be discarded into waste container 106 after exiting outlet 103 of flow cell 101. Fluidics controller 118 can control driving forces for reagents 114 and operation of valve 112 and valve block 116 with suitable software. Microwell array 107 includes an array of reaction regions as described herein, also referred to herein as microwells, which are operationally associated with corresponding chemical devices in the sensor array. For example, each reaction region can be coupled to a chemical device suitable for detecting an analyte or reaction property of interest within that reaction region. Microwell array 107 can be integrated in integrated circuit device 100, so that microwell array 107 and the sensor array are part of a single device or chip. Flow cell 101 can have a variety of configurations for controlling the path and flow rate of reagents 114 over microwell array 107. Array controller 124 provides bias voltages and timing and control signals to integrated circuit device 100 for reading the chemical devices of the sensor array. Array controller 124 also provides a reference bias voltage to reference electrode 108 to bias reagents 114 flowing over microwell array 107.

During an experiment, array controller 124 collects and processes output signals from the chemical devices of the sensor array through output ports on integrated circuit device 100 via bus 127. Array controller 124 can be a computer or other computing means. The array controller can include memory for storage of data and software applications, a processor for accessing data and executing applications, and components that facilitate communication with the various components of the system in FIG. 1.

The values of the output signals of the chemical devices indicate physical or chemical parameters of one or more reactions taking place in the corresponding reaction regions in the microwell array. For example, in an exemplary embodiment, the values of the output signals can be processed using the techniques disclosed in Rearick et al., U.S. Pat. Appl. No. 13/339,846, filed December 29, 2011, based on U.S. Prov. Pat. Appl. Nos. 61/428,743, filed December 30, 2010, and 61/429,328, filed January 3, 2011, and in Hubbell, U.S. Pat. Appl. No. 13/339,753, filed December 29, 2011, based on U.S. Prov. Pat. Appl. No 61/428,097, filed December 29, 2010, which are all incorporated by reference herein in their entirety.

User interface 128 can display information about flow cell 101 and the output signals received from chemical devices in the sensor array on integrated circuit device 100. User interface 128 can also display instrument settings and controls, and allow a user to enter or set instrument settings and controls.

In an exemplary embodiment, during the experiment fluidics controller 118 can control delivery of individual reagents 114 to flow cell 101 and integrated circuit device 100 in a predetermined sequence, for predetermined durations, at predetermined flow rates. Array controller 124 can collect and analyze the output signals of the chemical devices indicating chemical reactions occurring in response to the delivery of reagents 114. During the experiment, the system can also monitor and control the temperature of the integrated circuit device, so that reactions take place and measurements are made at a known predetermined temperature. The system can be configured to let a single fluid or reagent contact reference electrode 108 throughout an entire multi-step reaction during operation. Valve 112 can be shut to prevent any wash solution 110 from flowing into passage 109 as reagents 114 are flowing. Although the flow of wash solution can be stopped, there can still be uninterrupted fluid and electrical communication between reference electrode 108, passage 109, and microwell array 107. The distance between reference electrode 108 and the junction between passages 109 and 111 can be selected so that little or no amount of the reagents flowing in passage 109 and possibly diffusing into passage 111 reach reference electrode 108. In an exemplary embodiment, wash solution 110 can be selected as being in continuous contact with reference electrode 108, which can be especially useful for multi-step reactions using frequent wash steps.

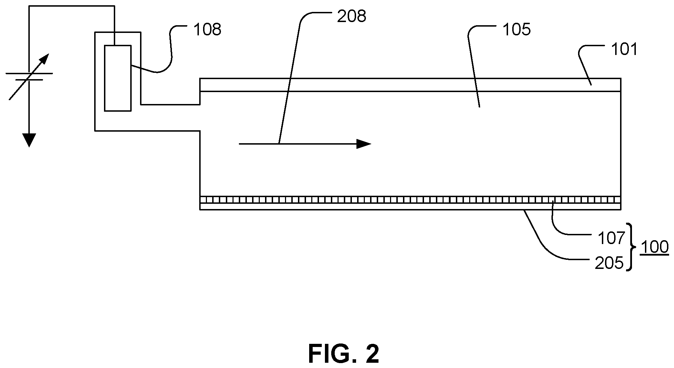

FIG. 2 illustrates a cross-sectional view of a portion of integrated circuit device 100 and flow cell 101. During operation, flow chamber 105 of flow cell 101 confines a reagent flow 208 of delivered reagents across open ends of the reaction regions in microwell array 107. The volume, shape, aspect ratio (such as base width-to-well depth ratio), and other dimensional characteristics of the reaction regions can be selected based on the nature of the reaction taking place, as well as the reagents, byproducts, or labeling techniques (if any) that are employed. The chemical devices of the sensor array 205 are responsive to (and generate output signals) chemical reactions within associated reaction regions in microwell array 107 to detect an analyte or reaction property of interest. The chemical devices of sensor array 205 can, for example, be chemically sensitive field-effect transistors (chemFETs), such as ion-sensitive field effect transistors (ISFETs). Examples of chemical devices and array configurations that can be used in embodiments are described in U.S. Patent Application Publication No. 2010/0300559, No. 2010/0197507, No. 2010/0301398, No. 2010/0300895, No. 2010/01307a43, and No. 2009/0026082, and U.S. Patent No. 7,575,865, each of which are incorporated by reference herein in their entirety.

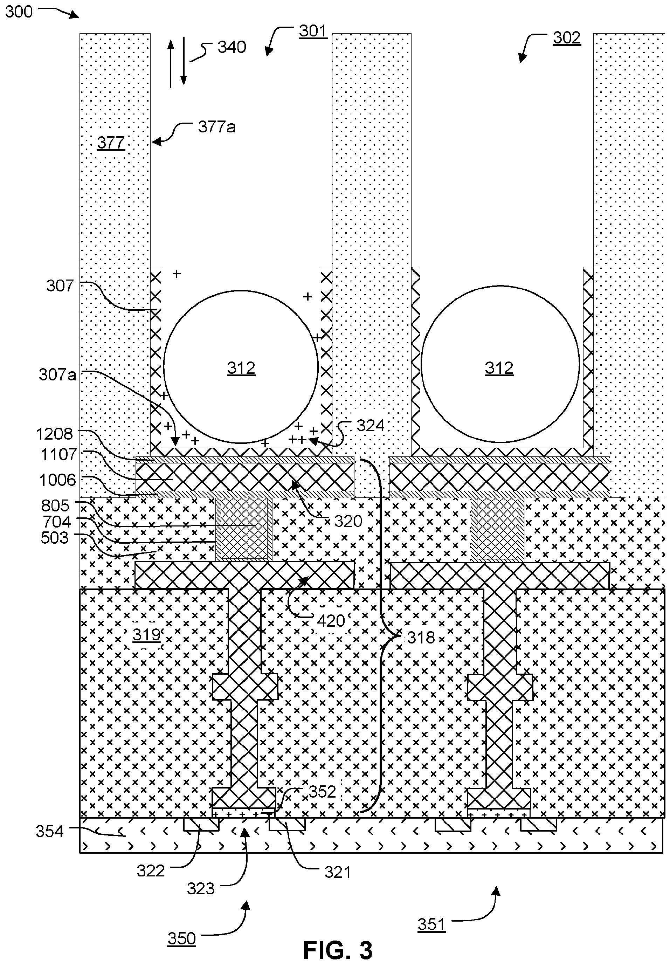

FIG. 3 illustrates a cross-sectional view of two representative chemical devices and their corresponding reaction regions according to an exemplary embodiment. In FIG. 3, two chemical devices 350, 351 are shown, representing a small portion of a sensor array that can include millions of chemical devices. Chemical device 350 is coupled to corresponding reaction region 301, and chemical device 351 is coupled to corresponding reaction region 302. The reaction regions 301 and 302 can be formed from wells and openings defined in structures described in more detail below. Chemical device 350 is representative of the chemical devices in the sensor array. In the illustrated example, chemical device 350 is a chemically-sensitive field effect transistor (chemFET), more specifically an ion-sensitive field effect transistor (ISFET) in this example. Chemical device 350 includes a floating gate structure 318 having a sensor plate 320 coupled to reaction region 301 by a conductive element 307. As is illustrated in FIG. 3, sensor plate 320 is an uppermost floating gate conductor in floating gate structure 318. In the illustrated example, floating gate structure 318 includes multiple patterned layers of conductive material within layers of dielectric material 319. Chemical device 350 also includes a source region 321 and a drain region 322 within a semiconductor substrate 354. Source region 321 and drain region 322 comprise doped semiconductor material having a conductivity type different from the conductivity type of substrate 354. For example, source region 321 and drain region 322 can comprise doped P-type semiconductor material, and the substrate can comprise doped N-type semiconductor material. Channel region 323 separates source region 321 and drain region 322. Floating gate structure 318 can overlies channel region 323, and is separated from substrate 354 by a gate dielectric 352. Gate dielectric 352 can be silicon dioxide, for example. Alternatively, other dielectrics can be used for gate dielectric 352.

As shown in FIG. 3, dielectric material 377 defines reaction region 301 which can be within a well or an opening defined by an absence of dielectric material. The dielectric material can comprise one or more layers of material, such as silicon dioxide or silicon nitride or any other suitable material or mixture of materials. The dimensions of the openings, and their pitch, can vary from implementation to implementation. In some embodiments, the openings can have a characteristic diameter, defined as the square root of 4 times the plan view cross-sectional area (A) divided by Pi (e.g., sqrt(4^{∗}A/π), of not greater than 5 micrometers, such as not greater than 3.5 micrometers, not greater than 2.0 micrometers, not greater than 1.6 micrometers, not greater than 1.0 micrometers, not greater than 0.8 micrometers, not greater than 0.6 micrometers, not greater than 0.4 micrometers, not greater than 0.2 micrometers or not greater than 0.1 micrometers, but at least 0.001 micrometers, such as at least 0.01 micrometers.

Chemical device 350 includes a conductive element 307 overlying and in communication with an uppermost floating gate conductor in the plurality of floating gate conductors. Upper surface 307a of conductive element 307 acts as the sensing surface for the chemical device 350. The conductive element as discussed throughout the disclosure can be formed in various shapes (width, height, etc.) depending on the materials/etch techniques/fabrication processes, etc. used during the manufacture process. Conductive element 307 can comprise one or more of a variety of different materials to facilitate sensitivity to particular ions (e.g. hydrogen ions). Accordingly to an exemplary embodiment, the conductive element can comprise at least one of titanium, tantalum, titanium nitrite, or aluminum, or oxides or mixtures thereof. Conductive element 307 allows chemical device 350 to have a sufficiently large surface area to avoid the noise issues associated with small sensing surfaces. The plan view area of the chemical device is determined in part by the width (or diameter) of reaction region 301 and can be made small, allowing for a high density array. In addition, because reaction region 301 is defined by upper surface 307a of conductive element 307 and an inner surface 377a of dielectric material 377, the sensing surface area can depend upon the depth and the circumference of reaction region 301, and can be relatively large. As a result, low noise chemical devices 350, 351 can be provided in a high density array, such that the characteristics of reactions can be accurately detected.

During manufacturing or operation of the device, a thin oxide of the material of conductive element 307 can be grown on upper surface 307a which acts as a sensing material (e.g. an ion-sensitive sensing material) for chemical device 350. For example, in one embodiment the electrically conductive element can be titanium or titanium nitride. Titanium oxide or titanium oxynitride can be grown on upper surface 307a during manufacturing or during exposure to solutions during use. Whether an oxide is formed depends on the conductive material, the manufacturing processes performed, and the conditions under which the device is operated. In the illustrated example, conductive element 307 is shown as a single layer of material. More generally, the electrically conductive element can comprise one or more layers of a variety of electrically conductive materials, such as metals or ceramics, or any other suitable conductive material or mixture of materials, depending upon the implementation. The conductive material can be, for example, a metallic material or alloy thereof, or can be a ceramic material, or a combination thereof. An exemplary metallic material includes one of aluminum, copper, nickel, titanium, silver, gold, platinum, hafnium, lanthanum, tantalum, tungsten, iridium, zirconium, palladium, or a combination thereof. An exemplary ceramic material includes one of titanium nitride, titanium aluminum nitride, titanium oxynitride, tantalum nitride, or a combination thereof.

In some alternative embodiments, an additional conformal sensing material (not shown) is deposited on the upper surface 307a of conductive element 307. The sensing material can comprise one or more of a variety of different materials to facilitate sensitivity to particular ions. For example, silicon nitride or silicon oxynitride, as well as metal oxides such as silicon oxide, aluminum or tantalum oxides, generally provide sensitivity to hydrogen ions, whereas sensing materials comprising polyvinyl chloride containing valinomycin provide sensitivity to potassium ions. Materials sensitive to other ions such as sodium, silver, iron, bromine, iodine, calcium, and nitrate can also be used, depending upon the implementation.

Referring to FIG. 3, in operation, reactants, wash solutions, and other reagents can move in and out of reaction region 301 by a diffusion mechanism 340. Chemical device 350 is responsive to (and generates an output signal related to) an amount of charge 324 proximate to conductive element 307. The presence of charge 324 in an analyte solution alters the surface potential at the interface between the analyte solution and upper surface 307a of conductive element 307, due to the protonation or deprotonation of surface charge groups caused by the ions present in the analyte solution. Changes in the charge 324 cause changes in the voltage on the floating gate structure 318, which in turn changes in the threshold voltage of the transistor of the chemical device 350. This change in threshold voltage can be measured by measuring the current in channel region 323 between source region 321 and drain region 322. As a result, chemical device 350 can be used directly to provide a current-based output signal on an array line connected to source region 321 or drain region 322, or indirectly with additional circuitry to provide a voltage-based output signal.

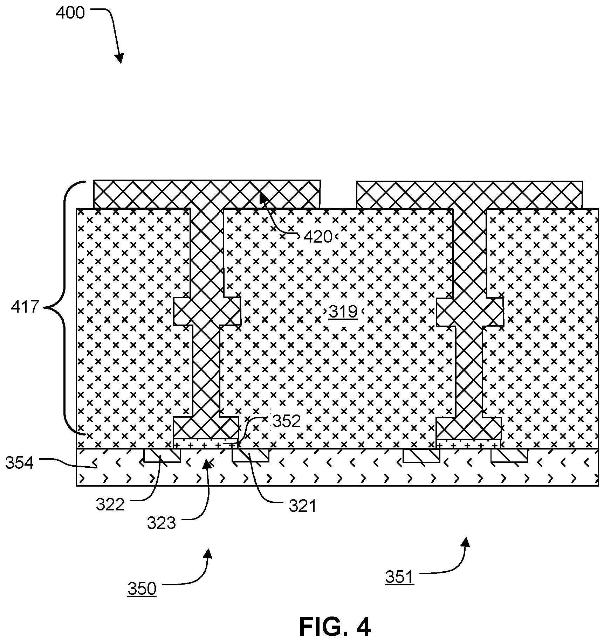

As described in more detail below with respect to FIGS. 4-25, conductive element 307 is overlying and in communication with an uppermost floating gate conductor, sensor plate 320. Because charge 324 can be more highly concentrated near the bottom of reaction region 301, in some embodiments variations in the dimensions of the conductive element can have a significant effect on the amplitude of the signal detected in response to charge 324. In an embodiment, reactions carried out in reaction region 301 can be analytical reactions to identify or determine characteristics or properties of an analyte of interest. Such reactions can generate directly or indirectly byproducts that affect the amount of charge adjacent to conductive element 307. If such byproducts are produced in small amounts or rapidly decay or react with other constituents, multiple copies of the same analyte can be analyzed in the reaction region 301 at the same time in order to increase the output signal generated. In an embodiment, multiple copies of an analyte can be attached to a solid phase support 312, either before or after deposition into reaction region 301. Solid phase support 312 can be microparticles, nanoparticles, beads, solid or porous comprising gels, or the like. For simplicity and ease of explanation, solid phase support 312 is also referred herein as a particle. Solid phase support can be of varied size. Further, the solid support can be positioned in the opening at various places. For a nucleic acid analyte, multiple, connected copies can be made by rolling circle amplification (RCA), exponential RCA, polymerase chain reaction (PCR) or like techniques, to produce an amplicon without the need of a solid support.

In various exemplary embodiments, the methods, systems, and computer readable media described herein can advantageously be used to process or analyze data and signals obtained from electronic or charged-based nucleic acid sequencing. In electronic or charged-based sequencing (such as, pH-based sequencing), a nucleotide incorporation event can be determined by detecting ions (e.g., hydrogen ions) that are generated as natural by-products of polymerase-catalyzed nucleotide extension reactions. This can be used to sequence a sample or template nucleic acid, which can be a fragment of a nucleic acid sequence of interest, for example, and which can be directly or indirectly attached as a clonal population to a solid support, such as a particle, microparticle, bead, etc. The sample or template nucleic acid can be operably associated to a primer and polymerase and can be subjected to repeated cycles or "flows" of deoxynucleoside triphosphate ("dNTP") addition (which can be referred to herein as "nucleotide flows" from which nucleotide incorporations can result) and washing. The primer can be annealed to the sample or template so that the primer's 3' end can be extended by a polymerase whenever dNTPs complementary to the next base in the template are added. Then, based on the known sequence of nucleotide flows and on measured output signals of the chemical devices indicative of ion concentration during each nucleotide flow, the identity of the type, sequence and number of nucleotide(s) associated with a sample nucleic acid present in a reaction region coupled to a chemical device can be determined.

FIGS. 4-25 illustrate stages in a manufacturing process for forming an array of chemical devices and corresponding well structures according to an exemplary embodiment. FIG. 4 illustrates a structure 400 including floating gate structures (e.g. floating gate structure 417) for chemical devices 350, 351. Structure 400 can be formed by depositing a layer of gate dielectric material on semiconductor substrate 354, and depositing a layer of polysilicon (or other electrically conductive material) on the layer of gate dielectric material. The layer of polysilicon and the layer gate dielectric material can then be etched using an etch mask to form the gate dielectric elements (e.g. gate dielectric 352) and the lowermost conductive material element of the floating gate structures. Following formation of an ion-implantation mask, ion implantation can then be performed to form the source and drain regions (e.g. source region 321 and a drain region 322) of the chemical devices. A first layer of dielectric material 319 can be deposited over the lowermost conductive material elements. Conductive plugs can then be formed within vias etched in the first layer of dielectric material 319 to contact the lowermost conductive material elements of the floating gate structures. A layer of conductive material can then be deposited on the first layer of dielectric material 319 and patterned to form second conductive material elements electrically connected to the conductive plugs. This process can then be repeated multiple times to form the completed floating gate structure 317 shown in FIG. 4. Alternatively, other or additional techniques can be performed to form the structure. For example, as seen in FIG. 3 and as described below, an additional conductor can be built on top of the stack of conductors, together grouped and labeled 318. Further, forming structure 400 in FIG. 4 can also include forming additional elements such as array lines (e.g. word lines, bit lines, etc.) for accessing the chemical devices, additional doped regions in substrate 354, and other circuitry (e.g. access circuitry, bias circuitry etc.) used to operate the chemical devices, depending upon the device and array configuration in which the chemical devices described herein are implemented. In some embodiments, the elements of the structure can, for example, be manufactured using techniques described in U.S. Patent Application Publication No. 2010/0300559, No. 2010/0197507, No. 2010/0301398, No. 2010/0300895, No. 2010/013071a43, and No. 2009/0026082, and U.S. Patent No. 7,575,865, each of which were incorporated by reference in their entirety above.

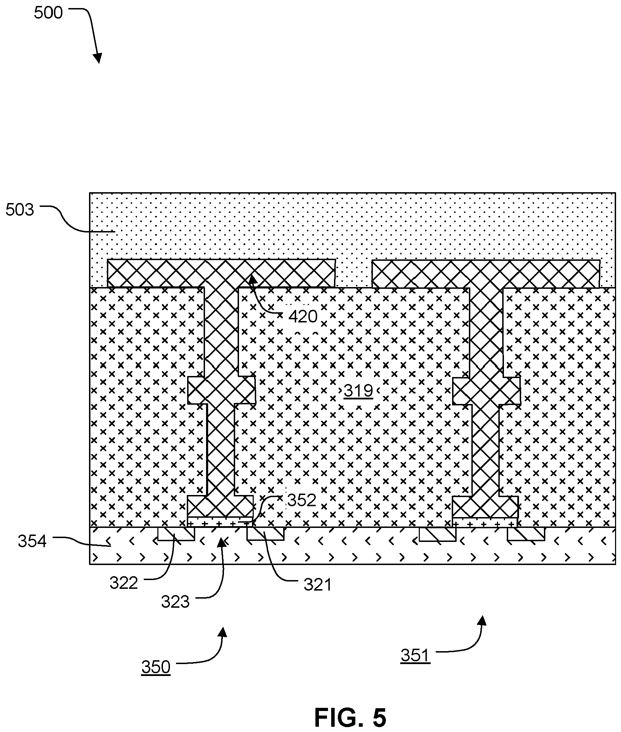

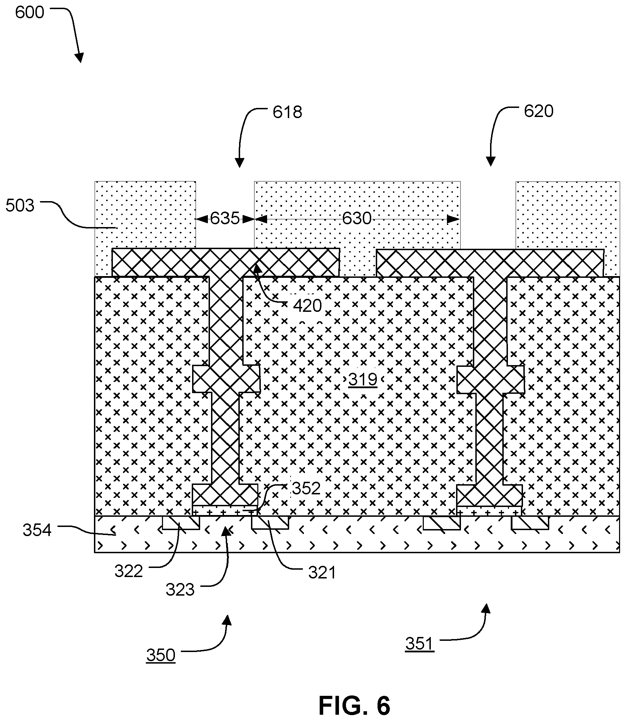

As illustrated in structure 500 illustrated in FIG. 5, a dielectric material 503 can be formed on conductor plate 420 of the field effect transistor of chemical device 350. Conductor plate 420 and sensor plate 320 can be the same size of one can be larger or smaller than the other; wider or thinner than the other; thicker of thinner than the other, for example. As illustrated in FIG. 6, dielectric material 503 of structure 500 in FIG. 5 is etched to form openings 618, 620 (for vias) extending to conductor plate 420 of the floating gate structures of chemical devices 350, 351, resulting in structure 600 illustrated in FIG. 6. Openings 618, 620 can, for example, be formed by using a lithographic process to pattern a layer of photoresist on dielectric material 503 to define the locations of openings 618, 620, and then anisotropically etching dielectric material 503 using the patterned photoresist as an etch mask. The anisotropic etching of dielectric material 503 can, for example, be a dry etch process, such as a fluorine based Reactive Ion Etching (RIE) process. In the illustrated embodiment, openings 618, 620 are separated by a distance 630 and openings 618, 620 are of a suitable dimension for a via. For example, separation distance 630 can be a minimum feature size for the process (e.g. a lithographic process) used to form openings 618, 620. In such a case, distance 630 can be significantly greater than distance 635. The process described for fabricating the vias above can be the same fabrication process for fabrication of some of or of all of the vias in the floating gate.

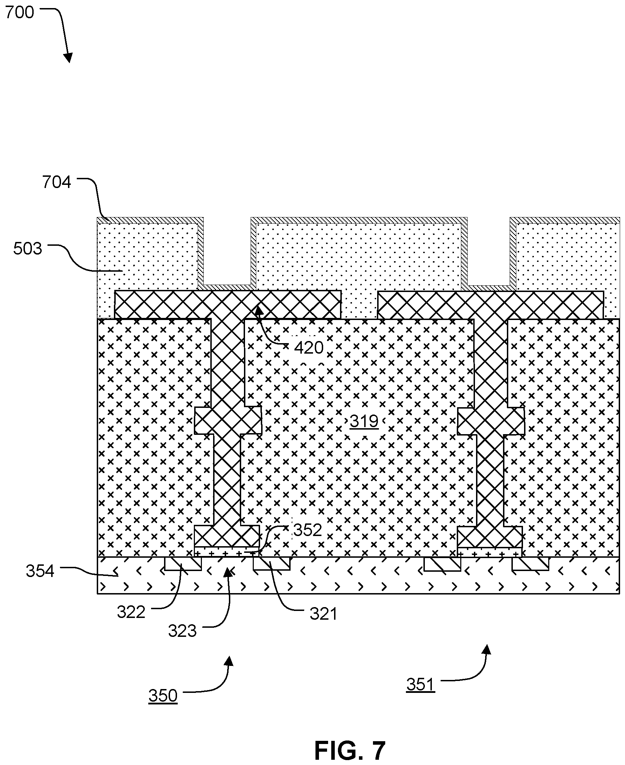

A layer of conductive material 704 is deposited on structure 600 illustrated in FIG. 6, resulting in structure 700 illustrated in FIG. 7. Conductive material 704 can be referred to as a conductive liner. Conductive material 704 can comprise one or more layers of electrically conductive material. For example, conductive material 704 can be a layer of titanium nitride, or a layer of titanium. Alternatively, other or additional conductive materials can be used, such as those described above with reference to the electrically conductive element. In addition, more than one layer of conductive material can be deposited. Conductive material 704 can be deposited using various techniques, such as sputtering, reactive sputtering, atomic layer deposition (ALD), low pressure chemical vapor deposition (LPCVD), plasma enhanced chemical vapor deposition (PECVD), metal organic chemical vapor deposition (MOCVD), etc..

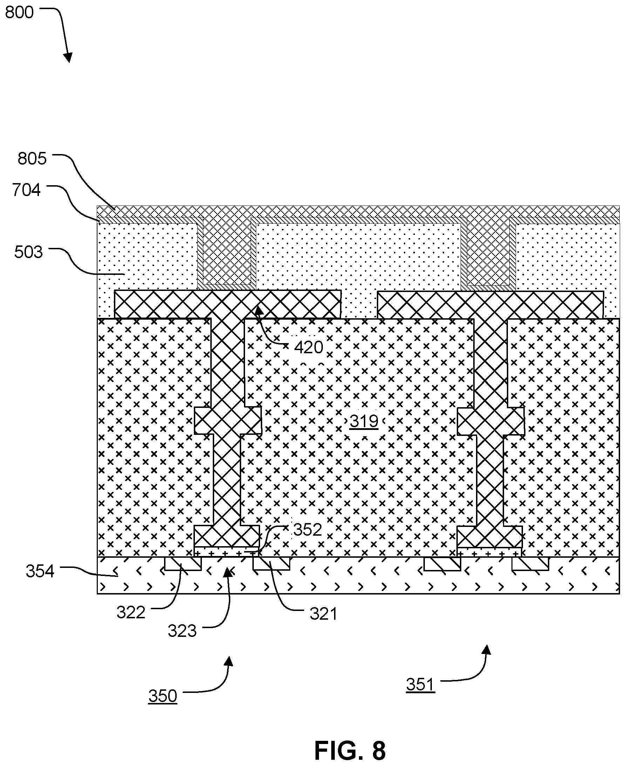

A layer of conductive material 805 such as tungsten, for example, is deposited on structure 700 illustrated in FIG. 7, resulting in structure 800 illustrated in FIG. 8. Conductive material 805 can be deposited using various techniques, such as sputtering, reactive sputtering, atomic layer deposition (ALD), low pressure chemical vapor deposition (LPCVD), plasma enhanced chemical vapor deposition (PECVD), metal organic chemical vapor deposition (MOCVD), etc. or any other suitable techniques.

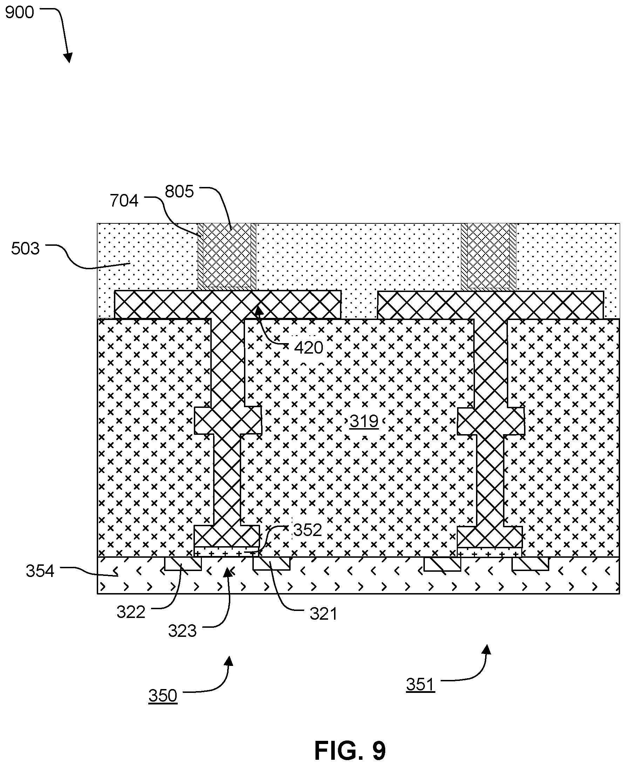

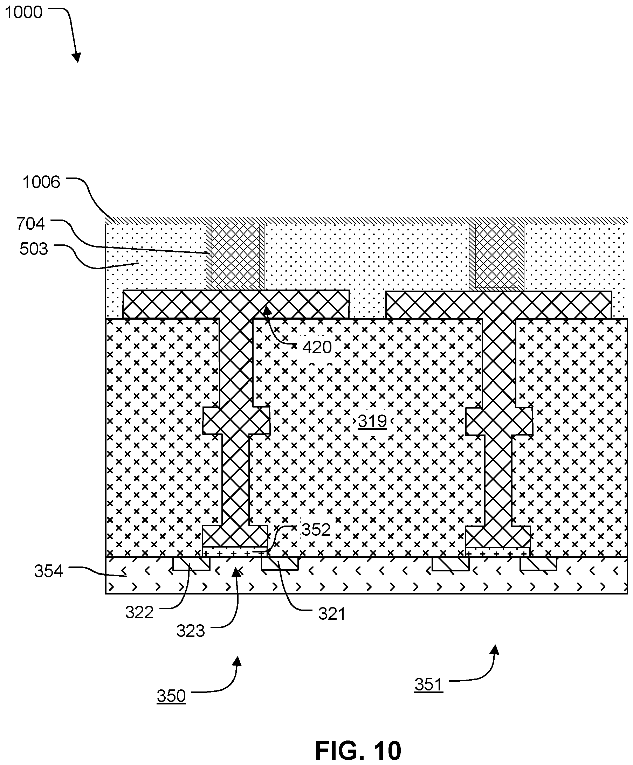

Conductive material 704 and conductive material 805 are planarized using a Chemical Mechanical Planarization (CMP) process, for example, resulting in structure 900 illustrated in FIG. 9. As an optional, additional step, a via barrier liner 1006 can be formed on planarized conductive material 704 and conductive material 805, resulting in structure 1000 illustrated in FIG. 10. For example, via barrier liner 1006 can be titanium nitride. Alternatively, other or additional conductive materials can be used. While via barrier liner 1006 is illustrated in FIGS. 3 and 10-25, via barrier liner 1006 can be optional.

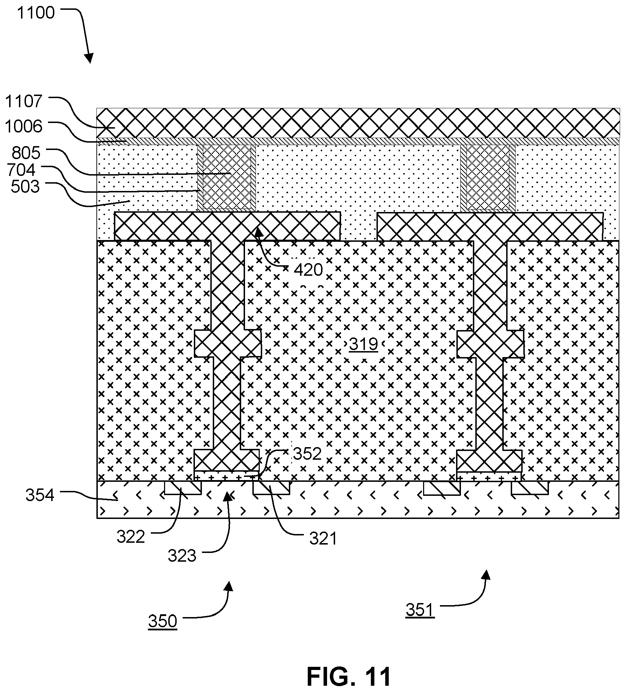

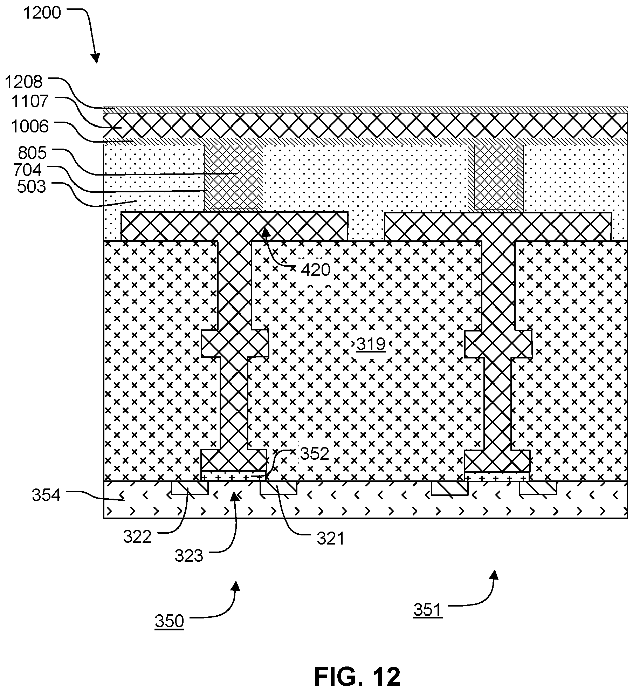

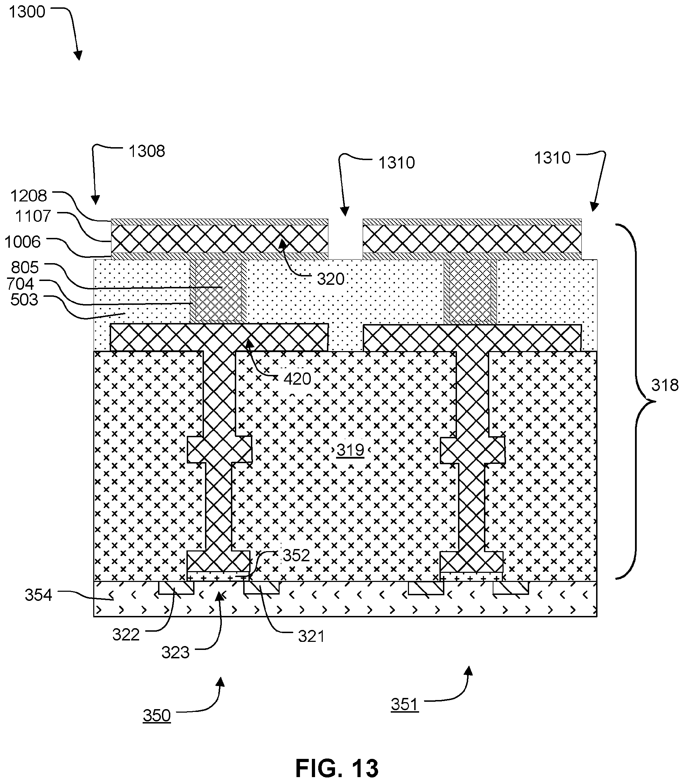

A conductive material 1107 can be formed on via barrier liner 1006, resulting in structure 1100 illustrated in FIG.11. Conductive material 1107 can comprise same material as the material used to form the conductors of the floating gate, for example. Optionally, conductive material 1107 can be formed directly on planarized conductive material 704 and conductive material 805. A barrier liner 1208 can be formed on the conductive material 1107, resulting in structure 1200 illustrated in FIG.12. For example, barrier liner 1208 can be titanium nitride. Alternatively, other or additional conductive materials can be used. While barrier liner 1208 is illustrated in the FIGS. 12-25, barrier liner 1208 is optional. Barrier liner 1208, conductive material 1107, and via barrier liner 1006 are etched to form openings 1308, 1310, 1312 extending to dielectric material 503, resulting in sensor plate 320 being formed, as illustrated in structure 1300 of FIG. 13. Any suitable etch techniques and chemistries can be used to accomplished the above described step.

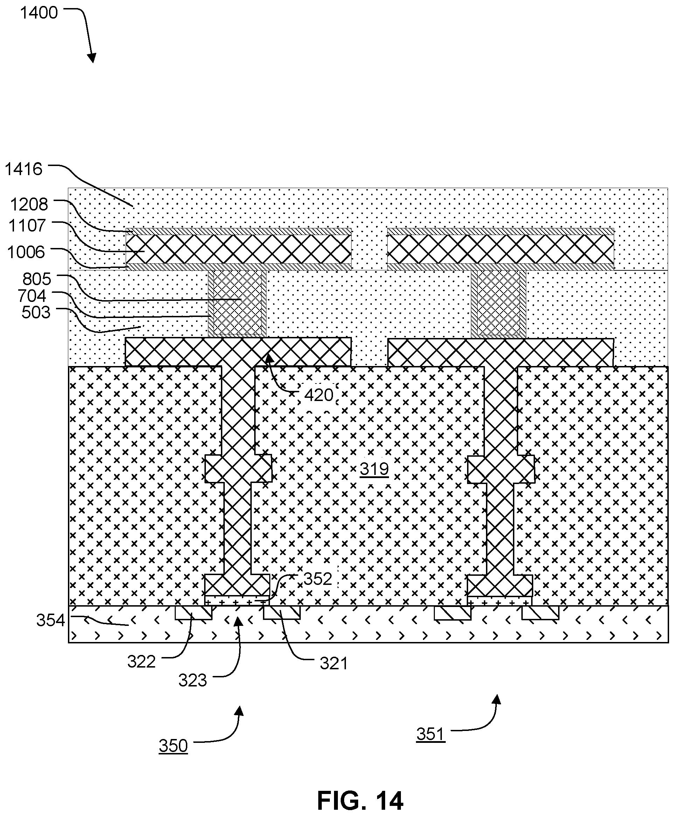

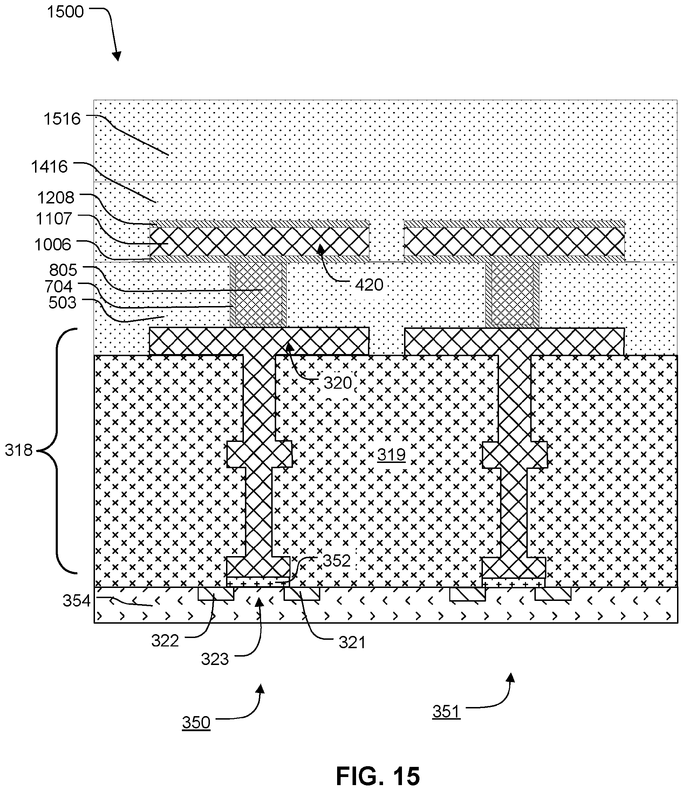

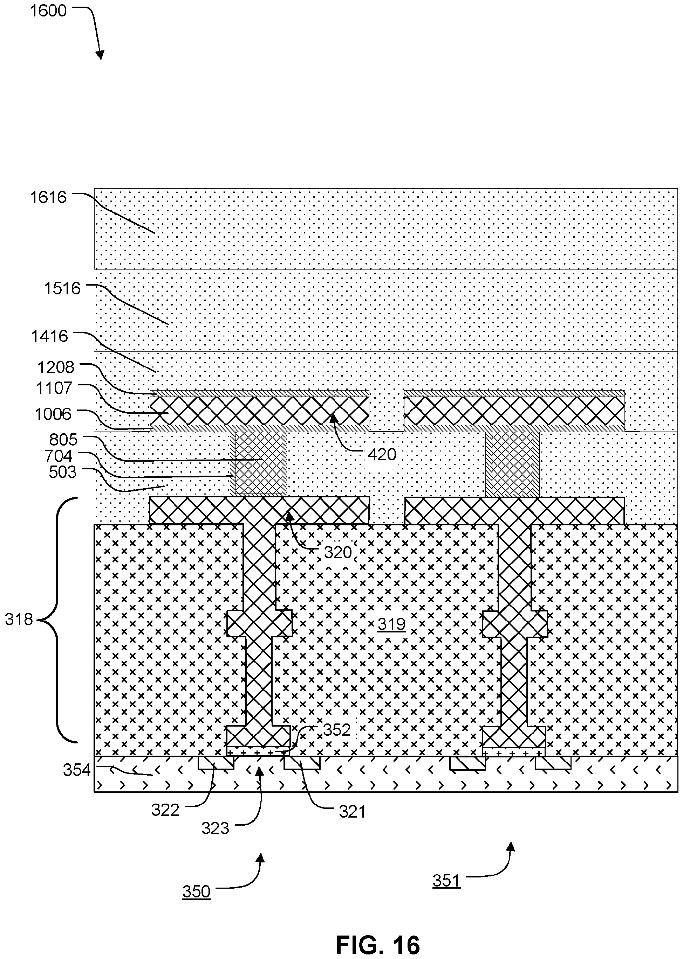

A dielectric material 1416 can be formed on structure 1300 illustrated in FIG. 13, resulting in structure 1400 illustrated in FIG.14. For example, dielectric material 1416 can be an oxide of silicon, such as a low temperature oxide of silicon, for example, derived from tetraethyl orthosilicate, (TEOS), or can be a high density silicon dioxide. Optionally or alternatively, another dielectric material 1516 can be formed on structure 1400 illustrated in FIG. 14, resulting in structure 1500 illustrated in FIG.15. For example, dielectric material 1516 can be a nitride of silicon, such as silicon nitride. Optionally, a further dielectric material 1616 can be formed on structure 1500 illustrated in FIG. 14, resulting in structure 1600 illustrated in FIG.16. For example, dielectric material 1616 can be a low temperature oxide of silicon, for example, derived from tetraethyl orthosilicate, (TEOS) or can be a high density silicon dioxide. Alternatively, rather than alternating dielectric materials to form a stack of three alternating dielectrics (HDO/SN/TEOS) a single dielectric can be deposited, for example, a single TEOS dielectric layer. In another example, the dielectric layer can be singularly formed of a silicon nitride or can be singularly formed of a high density silicon dioxide. In combination, the dielectric material layer or layers 1416, 1516, or 1616 can define a well structure over the substrate and over the gate structure.

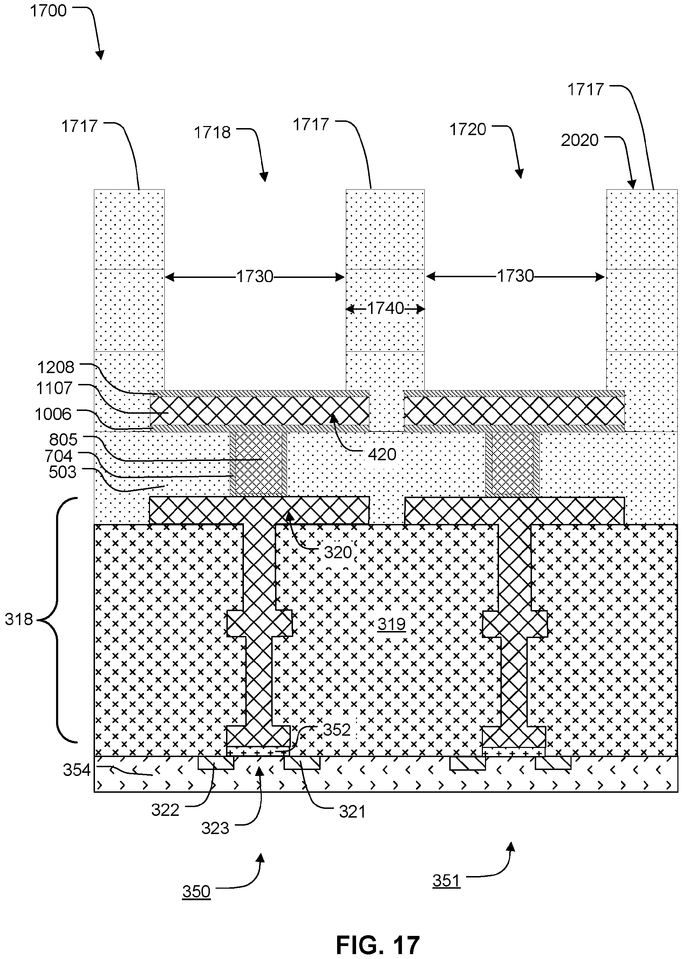

The well structure or dielectric material(s) is/are etched to form openings or wells 1718, 1720 extending to the upper surfaces of the floating gate structures of chemical devices 350, 351, resulting in structure 1700 illustrated in FIG. 17. An interstitial surface 1717 extends between the wells or openings. The wells or openings 1718, 1720 can, for example, be formed by using a lithographic process to pattern a layer of photoresist on the dielectric material to define the locations of openings 1718, 1720, and then anisotropically etching the dielectric material using the patterned photoresist as an etch mask. The anisotropic etching of the dielectric material can for example be a dry etch process, such as a fluorine based Reactive Ion Etching (RIE) process. In the illustrated embodiment, openings 1718, 1720 are separated by a distance 1730 that is greater than to distance 1740. Alternatively, separation distance 1730 between adjacent openings can be less than width 1740. For example, separation distance 1730 can be a minimum feature size for the process (e.g. a lithographic process) used to form openings 1718, 1720. In such a case, distance 1730 can be significantly greater than width 1740.

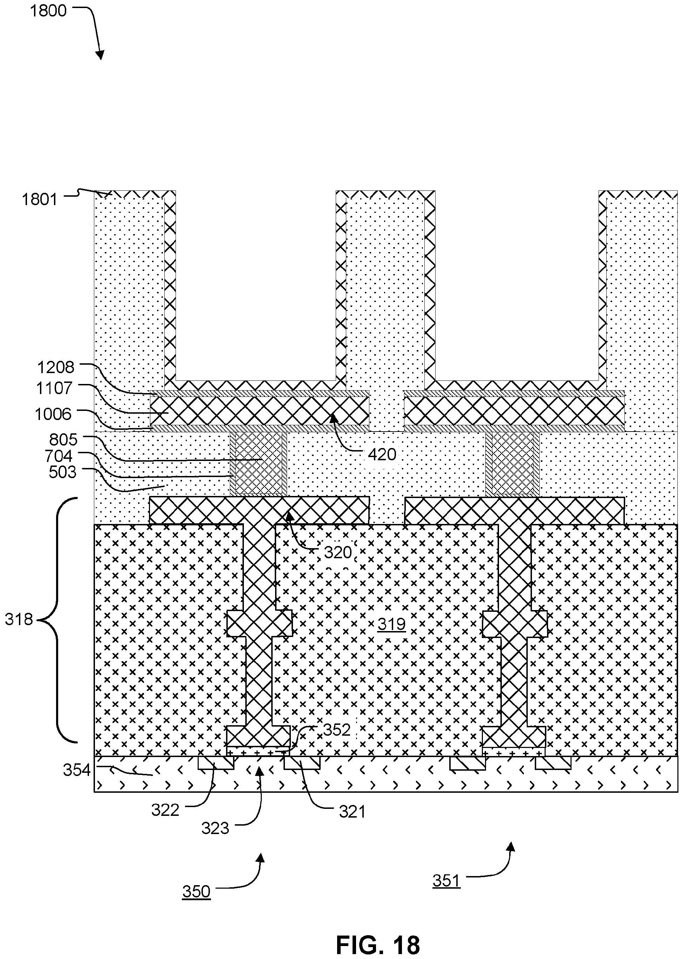

A layer of conductive material 1801 is deposited on the well structure illustrated in FIG. 17, resulting in structure 1800, illustrated in FIG. 18. The layer of conductive material 1801 can be a conformal layer. For example, the conformal layer extends along the bottom of the well and contacts the floating gate structure, extends along a wall of the well or opening, and extends over the interstitial surface 1717. Conductive material 1801 comprises one or more layers of electrically conductive material. For example, conductive material 1801 can be a layer of titanium, titanium nitride, or a layer of titanium. Alternatively, other or additional conductive materials can be used. For example, the conductive material 1801 can be a metal, e.g., selected from the group consisting of aluminum, copper, nickel, titanium, silver, gold, platinum, hafnium, lanthanum, tantalum, tungsten, iridium, zirconium, palladium, or a combination thereof. In another example, the conductive material 1801 can be a conductive ceramic, for example, selected from the group consisting of titanium nitride, titanium aluminum nitride, titanium oxynitride, tantalum nitride, or a combination thereof. In addition, more than one layer of conductive material can be deposited. The conductive material can be deposited such that the conductive material is a conformal layer. Conductive material 1801 can be deposited using various techniques, such as sputtering, reactive sputtering, atomic layer deposition (ALD), low pressure chemical vapor deposition (LPCVD), plasma enhanced chemical vapor deposition (PECVD), metal organic chemical vapor deposition (MOCVD), etc.

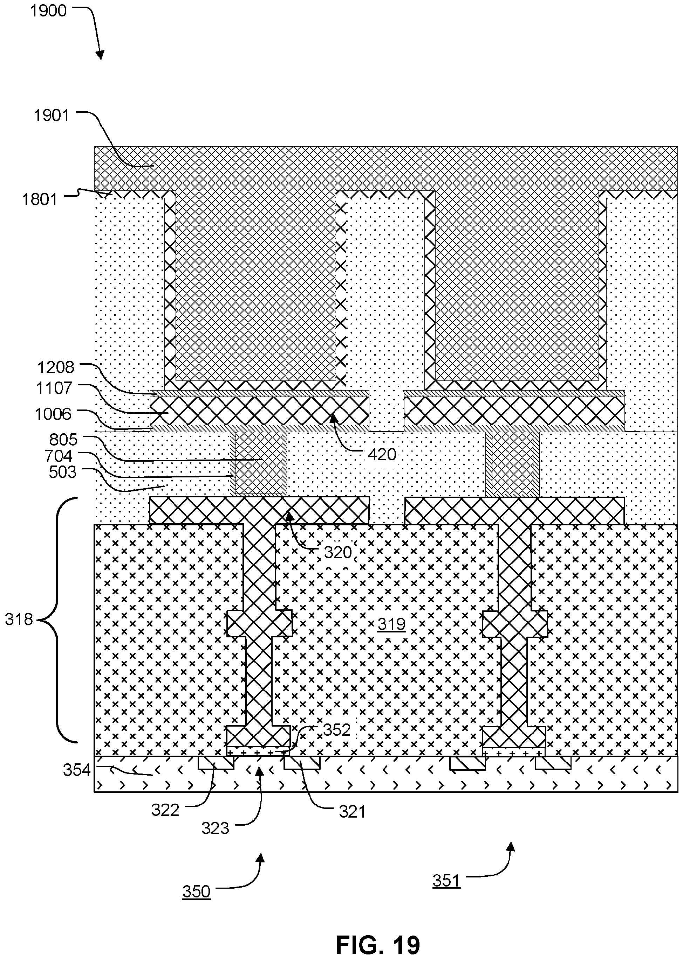

A fill material 1901 is formed on structure illustrated in FIG. 18, resulting in structure 1900, illustrated in FIG. 19. Fill material 1901 can comprise one or more layers of material, and can be deposited using various techniques. For example, fill material 1901 can be a layer of photoresist, polymer-based anti-reflective coating, polyimide, silicon dioxide, silicon nitride, etc. In an embodiment, the fill material can be tungsten. Fill material 1901 can be deposited using various techniques, such as spin coating, spray coating, sputtering, reactive sputtering, chemical vapor deposition, etc. Fill material 1901 comprises a material which can be selectively removed relative to conductive material 1801, and relative to the dielectric material.

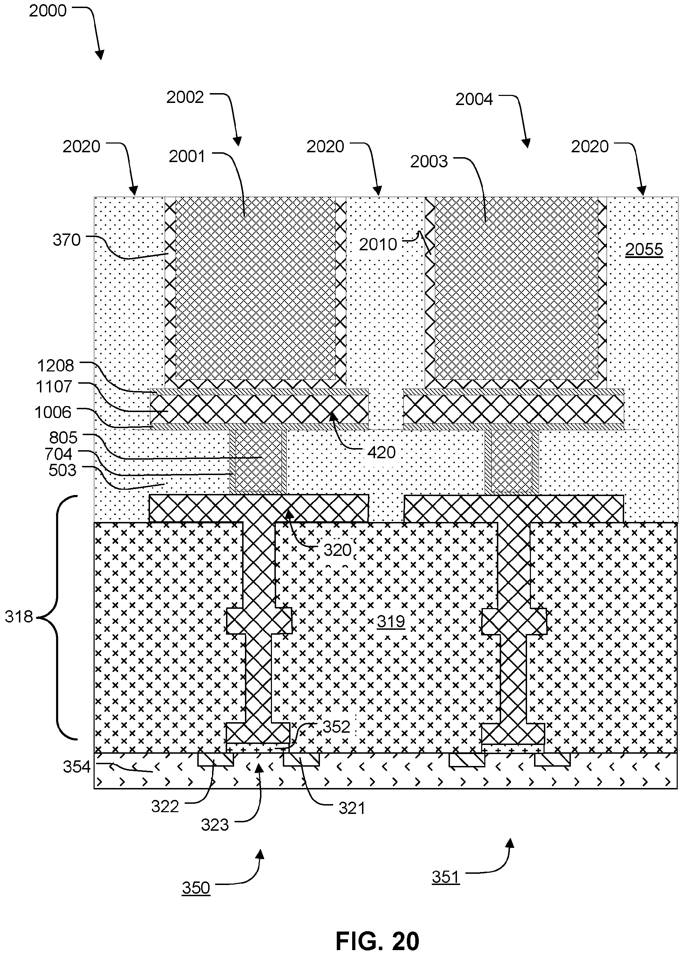

The fill material and at least a portion of the conformal conductive material extending over the interstitial surface 1717 can be removed. Removal can be through planarization or through etching. As illustrated in FIG. 20, a planarization process is performed to expose upper surface 2020 of the dielectric material 2055, resulting in structure 2000. For example, in one embodiment conductive material 1801 is titanium, and fill material is tungsten and the titanium and tungsten can be selectively removed using chemical mechanical polishing (CMP). In a particular example, CMP chemistry is switched following removal of the fill material to permit removal of the conductive material from the interstitial surface. The planarization process leaves remaining fill material elements 2002, 2004 within spaces 2001, 2003 and helps to form/define the cup-shaped electrically conductive elements 370, 2010.

Fill material elements 2002, 2004 protect the inner surfaces of electrically conductive elements 370, 2010, which subsequently act as the sensing surfaces for chemical sensors 350, 351, during the planarization process. That is, fill material elements 2002, 2004 are a protective mask during removal of conductive material 2010 from upper surface 2020 of dielectric material 2055. In doing so, damage to the sensing surfaces can be avoided. In addition, fill material elements 2002, 2004 act to protect and retain the shape of the openings by improving the mechanical stability of the structure during the planarization process, in particular for a small separation distance between adjacent openings in the dielectric. In the illustrated embodiment, the planarization process is a chemical mechanical polishing (CMP) process. Alternatively, other planarization processes can be used. In an alternative embodiment, rather than performing a planarization process, an etching process is performed to expose upper surface 2020 of dielectric material 2055. The etching process can for example be performed using a single etch chemistry to etch the fill material 1901 and conductive material 2010 overlying upper surface 2020 of dielectric material 2055. Alternatively, a first etch chemistry can be used to etch fill material 1901 and expose conductive material 2010 on upper surface 2020 of the dielectric material, and a second etch chemistry can be used to etch the exposed conductive material 2010 to expose upper surface 2020 of dielectric material 2055. For example, in one embodiment fill material 1901 is polyimide and can be removed using an oxygen plasma etch, while conductive material 2010 is titanium nitride and can be removed using a bromine based plasma etch. The etch process can use fewer steps and be faster. The etch process provides a surface that is rougher than the surface resulting from CMP. Such a rougher surface can result in surface patterns during deposition of subsequent layers.

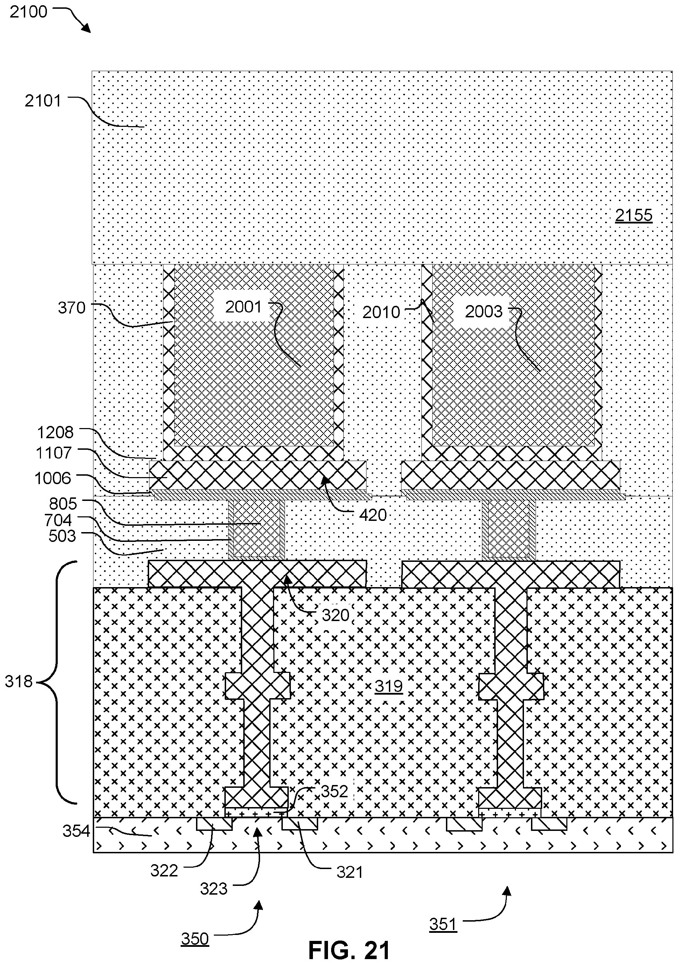

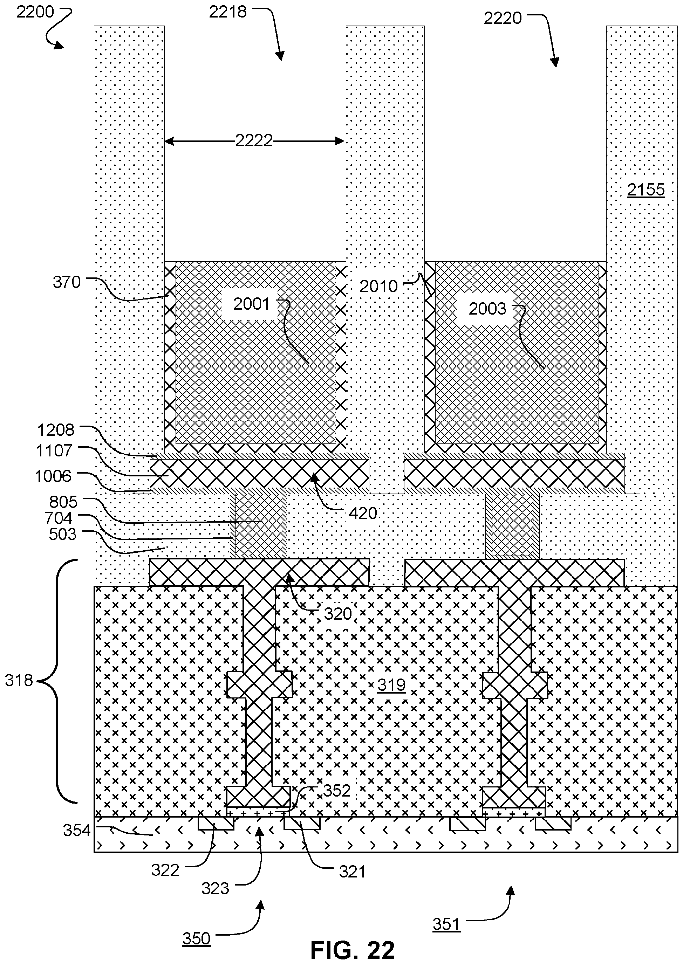

A layer of dielectric material 2101 is deposited on structure 2000 illustrated in FIG. 20, resulting in structure 2100, illustrated in FIG. 21. As illustrated in FIG. 22, dielectric material 2101 of structure 2100 in FIG. 21 is etched to form openings 2218, 2220 extending to fill material elements 2001, 2003, resulting in structure 2200 illustrated in FIG. 22. Openings 2218, 2220 can, for example, be formed by using a lithographic process to pattern a layer of photoresist on dielectric material 2155 to define the locations of openings 2218, 2220, and then anisotropically etching dielectric material 2155 using the patterned photoresist as an etch mask. The anisotropic etching of dielectric material 2155 can, for example, be a dry etch process, such as a fluorine based Reactive Ion Etching (RIE) process. The distance of the opening at the dielectric material is shown as 2222. Distance 2222 is large enough to accommodate loading an appropriately sized solid support (e.g. bead) into a corresponding well.

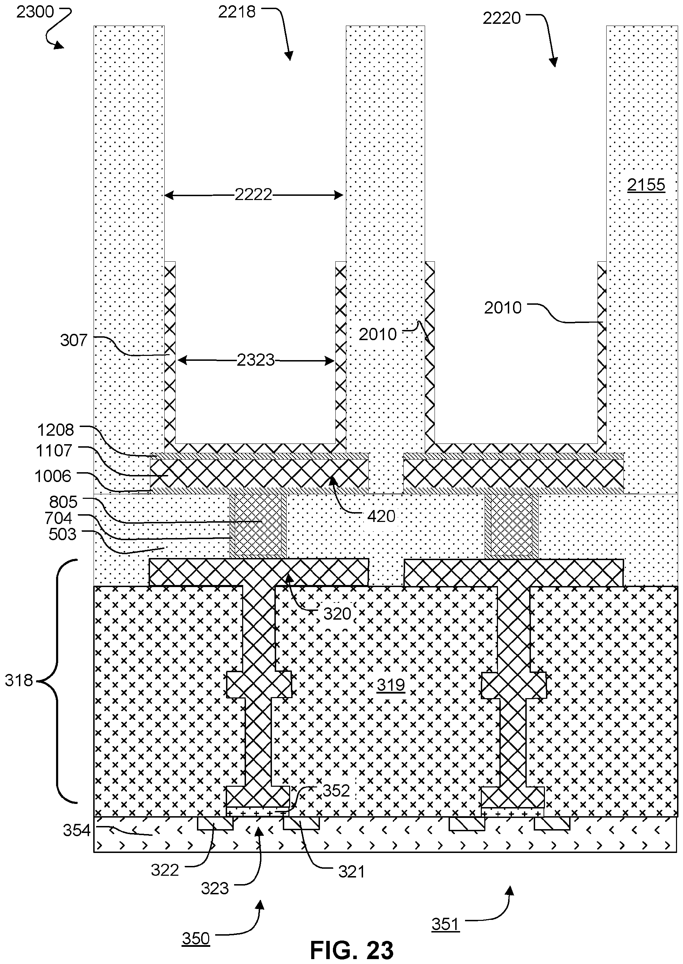

Fill material elements 2001, 2003 are removed to expose electrically conductive elements 370, 2010, resulting in structure 2300 illustrated in FIG. 23. Fill material elements 2001, 2003 can for example be removed using a wet etch or plasma etch process. The distance of the opening at the conductive element is shown as 2323. Distances 222 and 2323 are large enough to accommodate loading an appropriately sized solid support (e.g. bead) into a corresponding well.

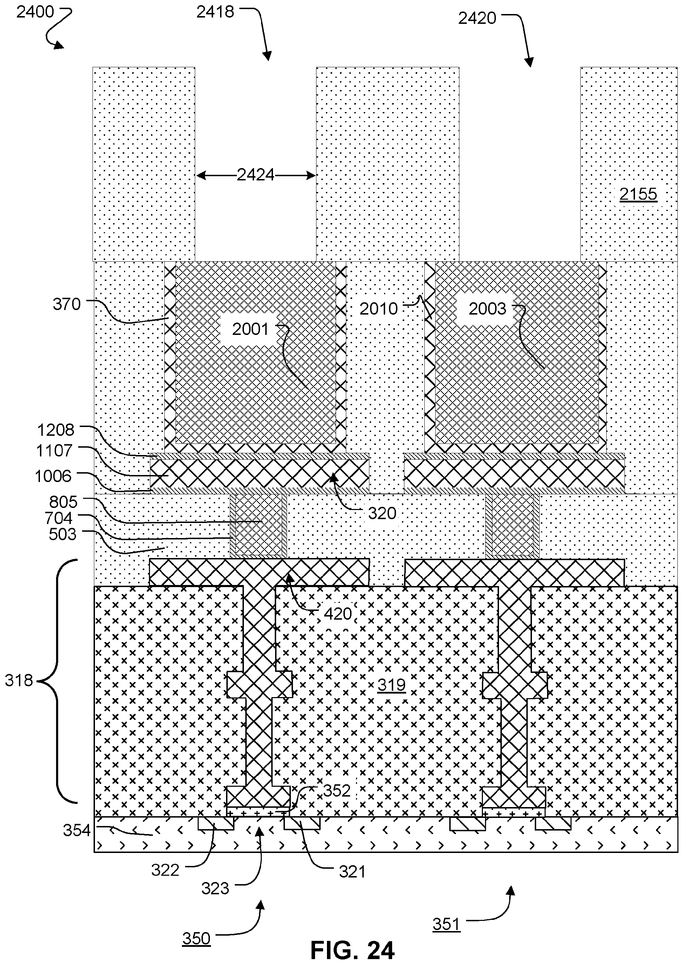

In an alternate embodiment, dielectric material 2101 of structure 2100 in FIG. 21 is etched to form openings 2418, 2420 extending to fill material elements 2001, 2003 and exposing the well or opening formed in the well structure, resulting in structure 2400 illustrated in FIG. 24. Openings 2418, 2420 can, for example, be formed by using a lithographic process to pattern a layer of photoresist on dielectric material 2155 to define the locations of openings 2418, 2420, and then anisotropically etching dielectric material 2155 using the patterned photoresist as an etch mask. The anisotropic etching of dielectric material 2155 can, for example, be a dry etch process, such as a fluorine based Reactive Ion Etching (RIE) process. The distance of the opening at the dielectric material is shown as 2424. Distance 2424 is large enough to accommodate loading an appropriately sized solid support (e.g. bead) into a corresponding well.

The thickness of the dielectric material 2101 can be thicker than the well structure. For example, a ratio of the thickness of the dielectric layer to the thickness of the well structure can be in a range of 1.01 to 10, such as a range of 1.05 to 3 or a range of 1.05 to 2.

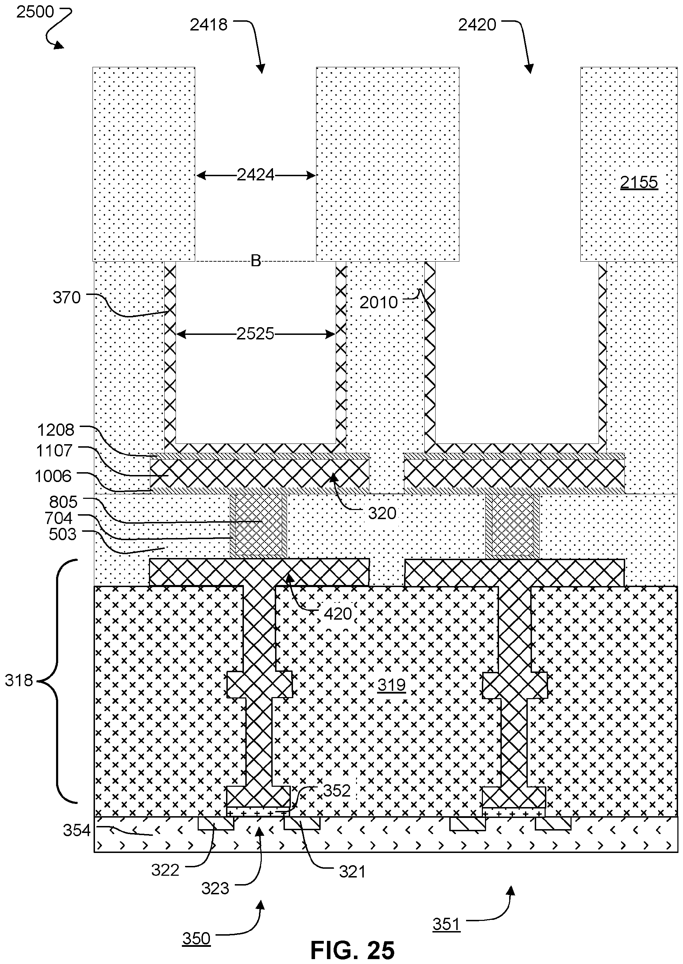

Fill material elements 2001, 2003 are removed to expose electrically conductive elements 370, 2010, resulting in structure 2500 illustrated in FIG. 25. Fill material elements 2001, 2003 can, for example, be removed using a wet etch or plasma etch process. The characteristic diameter of the opening at the conductive element is shown as 2525. Characteristic diameters 2424 and 2525 can be large enough to accommodate loading an appropriately sized solid support (e.g. bead) into a corresponding well. Characteristic diameter 2424 can be less than distance 2525 at an interface or boundary B between the well structure and the dielectric material 2101. In an embodiment, characteristic diameter 2424 is less than characteristic diameter 2525, resulting in a ledge, or overhang, created at boundary B of the two characteristic diameters 2424 and 2525. For example, a ratio of a characteristic diameter of the well at an interface between the well structure and the dielectric structure relative to a characteristic diameter of the opening at the interface is in a range of 1.01 to 2, such as a range of 1.01 to 1.5 or a range of 1.01 to 1.15.

### EXAMPLE

Using a wafer having wells defined in a well structure formed over a substrate, a conformal titanium layer is deposited over the well structure (2200A collimated Ti), and a coating of 6 micrometer HD8820 Photo-definable polyimide is deposited over the titanium. The polyimide is exposed and developed. Both an etch process and CMP process are tested for effect on well and opening formation.

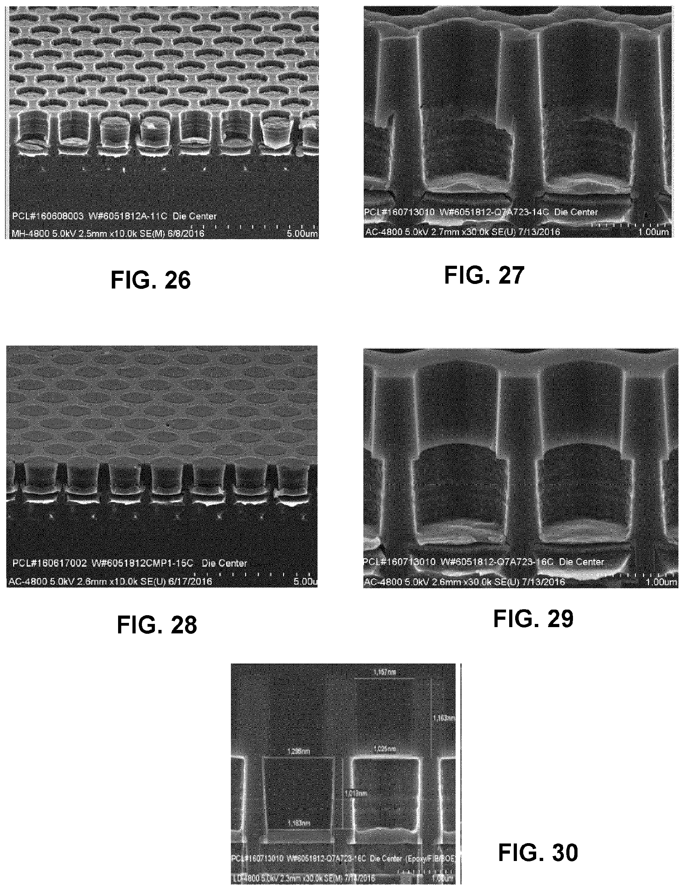

In the etch process, an oxygen-containing plasma (O2: 60 to 200 sccm; power: 61-90 W; 127 seconds) is used to remove polyimide. The titanium is subsequently etched from the interstitial surface. As illustrated in FIG. 26, the etch process removed both the polyimide and titanium from the interstitial space. The polyimide is recessed in the wells.

In the CMP process, two slurries are used. First, the wafer is polished using a slurry appropriate for removal of polyimide. Second, the wafer is polished using a slurry appropriate for removal of titanium. As illustrated in FIG. 28, the CMP process removed both the polyimide and titanium from the interstitial space. The surface is smoother than that produced by the etch process.

A dielectric layer is deposited over the well structure. A 1.2 micrometer layer of low temperature TEOS is deposited at 175°C. A pattern is etched in the TEOS layer, stopping on the polyimide. A long ash process followed by cleaning with NMP and aqueous solutions is used to remove the polyimide.

As illustrated in FIG. 27, the dielectric layer deposited following the above etch process to remove the polyimide and titanium from the interstitial surface results in an upper surface that is characterized by curved hills and valleys. In contrast, the dielectric layer deposited following a CMP removal is relative smooth, as illustrated in FIG. 28. In each case, however, openings to the wells are formed that exhibit an overhang at the boundary between the wells in the well structure and the openings in the dielectric layer, as illustrated in FIG. 30.

In a first aspect, an apparatus includes a substrate; a gate structure disposed over the substrate and having an upper surface; a well structure disposed over the substrate and defining a well over the upper surface of the gate structure; a conductive layer disposed on the upper surface of the gate structure and at least partially extending along a wall of the well in the well structure; and a dielectric structure disposed over the well structure and defining an opening to the well.

In an example of the first aspect, a characteristic diameter of the well at an interface between the well structure and the dielectric structure is greater than a characteristic diameter of the opening at the interface.

In another example of the first aspect, a characteristic diameter of the well at an interface between the well structure and the dielectric structure is approximately a characteristic diameter of the opening at the interface.

In a further example of the first aspect and the above examples, a ratio of a characteristic diameter of the well at an interface between the well structure and the dielectric structure relative to a characteristic diameter of the opening at the interface is in a range of 1.01 to 2. For example, the ratio is in a range of 1.01 to 1.5. In another example, the ratio is in a range of 1.01 to 1.15.

In an additional example of the first aspect and the above examples, the well structure comprises an oxide of silicon or a nitride of silicon.

In another example of the first aspect and the above examples, the well structure comprises a layer of an oxide of silicon and a layer of a nitride of silicon.

In a further example of the first aspect and the above examples, the conductive layer extends along the wall of the well to an interface between the well structure and the dielectric structure.

In an additional example of the first aspect and the above examples, the conductive layer comprises a metal. For example, the metal is selected from the group consisting of aluminum, copper, nickel, titanium, silver, gold, platinum, hafnium, lanthanum, tantalum, tungsten, iridium, zirconium, palladium, and a combination thereof.

In another example of the first aspect and the above examples, the conductive layer comprises a conductive ceramic material. For example, the conductive ceramic material is selected from the group consisting of titanium nitride, titanium aluminum nitride, titanium oxynitride, tantalum nitride, and a combination thereof.

In a further example of the first aspect and the above examples, the dielectric structure is thicker than the well structure.

In an additional example of the first aspect and the above examples, a ratio of the thickness of the dielectric layer to the thickness of the well structure is in a range of 1.01 to 10. For example, the ratio is in a range of 1.05 to 3. In a further example, the ratio is in a range of 1.05 to 2.

In another example of the first aspect and the above examples, the dielectric layer comprises a low temperature oxide of silicon.

In a further example of the first aspect and the above examples, the gate structure is a floating gate structure.

In an additional example of the first aspect and the above examples, the gate structure includes a barrier layer at the upper surface and in contact with the conductive layer.

In a second aspect, a method of forming a sensor device includes forming a well structure over a substrate, a gate structure disposed on the substrate and having an upper surface; forming a well in the well structure to expose the upper surface of the gate structure, the well including a well wall, the well structure defining an interstitial surface between wells; depositing conformally a conductive material over the well structure; removing the conductive material from the interstitial surface; forming a dielectric layer over the well structure; and forming an opening in the dielectric layer, the opening extending to the well.

In an example of the second aspect, forming the dielectric layer over the well structure comprises depositing a fill material into the well and depositing the dielectric layer over the well structure and the fill material in the well. For example, depositing the fill material into the well includes depositing the fill material over the well structure, the fill material entering the well, and removing excess fill material from over the well structure. In an example, removing the excess fill material includes performing chemical mechanical polishing of the fill material. For example, performing chemical mechanical polishing is stopped when the conductive material is detected. In an additional example, removing the excess fill material includes etching the fill material. For example, etching includes etching until the material of the conductive material is detected.

In another example of the second aspect and the above examples, a characteristic diameter of the well at an interface between the well structure and the dielectric structure is greater than a characteristic diameter of the opening at the interface.

In a further example of the second aspect and the above examples, a characteristic diameter of the well at an interface between the well structure and the dielectric structure is approximately a characteristic diameter of the opening at the interface.

In an additional example of the second aspect and the above examples, a ratio of a characteristic diameter of the well at an interface between the well structure and the dielectric structure relative to a characteristic diameter of the opening at the interface is in a range of 1.01 to 2.

In another example of the second aspect and the above examples, the well structure comprises an oxide of silicon or a nitride of silicon.

In a further example of the second aspect and the above examples, the well structure comprises a layer of an oxide of silicon and a layer of a nitride of silicon.

In an additional example of the second aspect and the above examples, the conductive layer extends along the wall of the well to an interface between the well structure and the dielectric structure.

In another example of the second aspect and the above examples, the conductive layer comprises a metal selected from the group consisting of aluminum, copper, nickel, titanium, silver, gold, platinum, hafnium, lanthanum, tantalum, tungsten, iridium, zirconium, palladium, and a combination thereof.

In a further example of the second aspect and the above examples, the conductive layer comprises a conductive ceramic material selected from the group consisting of titanium nitride, titanium aluminum nitride, titanium oxynitride, tantalum nitride, and a combination thereof.

In an additional example of the second aspect and the above examples, the dielectric structure is thicker than the well structure.

In another example of the second aspect and the above examples, a ratio of the thickness of the dielectric layer to the thickness of the well structure is in a range of 1.01 to 10.

In a further example of the second aspect and the above examples, the dielectric layer comprises a low temperature oxide of silicon.

In an additional example of the second aspect and the above examples, the gate structure is a floating gate structure.

In another example of the second aspect and the above examples, the gate structure includes a barrier layer at the upper surface and in contact with the conductive layer.

Note that not all of the activities described above in the general description or the examples are required, that a portion of a specific activity may not be required, and that one or more further activities can be performed in addition to those described. Still further, the order in which activities are listed are not necessarily the order in which they are performed.

In the foregoing specification, the concepts have been described with reference to specific embodiments. However, one of ordinary skill in the art appreciates that various modifications and changes can be made without departing from the scope of the invention as set forth in the claims below. Accordingly, the specification and figures are to be regarded in an illustrative rather than a restrictive sense, and all such modifications are intended to be included within the scope of invention.

As used herein, the terms "comprises," "comprising," "includes," "including," "has," "having" or any other variation thereof, are intended to cover a non-exclusive inclusion. For example, a process, method, article, or apparatus that comprises a list of features is not necessarily limited only to those features but may include other features not expressly listed or inherent to such process, method, article, or apparatus. Further, unless expressly stated to the contrary, "or" refers to an inclusive-or and not to an exclusive-or. For example, a condition A or B is satisfied by any one of the following: A is true (or present) and B is false (or not present), A is false (or not present) and B is true (or present), and both A and B are true (or present).

Also, the use of "a" or "an" are employed to describe elements and components described herein. This is done merely for convenience and to give a general sense of the scope of the invention. This description should be read to include one or at least one and the singular also includes the plural unless it is obvious that it is meant otherwise.

Benefits, other advantages, and solutions to problems have been described above with regard to specific embodiments. However, the benefits, advantages, solutions to problems, and any feature(s) that may cause any benefit, advantage, or solution to occur or become more pronounced are not to be construed as a critical, required, or essential feature of any or all the claims.

After reading the specification, skilled artisans will appreciate that certain features are, for clarity, described herein in the context of separate embodiments, may also be provided in combination in a single embodiment. Conversely, various features that are, for brevity, described in the context of a single embodiment, may also be provided separately or in any subcombination. Further, references to values stated in ranges include each and every value within that range.

Embodiments may be in accordance with the following numbered clauses:
1. An apparatus comprising:
   a substrate;
   a gate structure disposed over the substrate and having an upper surface;
   a well structure disposed over the substrate and defining a well over the upper surface of the gate structure;
   a conductive layer disposed on the upper surface of the gate structure and at least partially extending along a wall of the well in the well structure; and
   a dielectric structure disposed over the well structure and defining an opening to the well.
2. The apparatus of clause 1, wherein a characteristic diameter of the well at an interface between the well structure and the dielectric structure is greater than a characteristic diameter of the opening at the interface.
3. The apparatus of clause 1, wherein a characteristic diameter of the well at an interface between the well structure and the dielectric structure is approximately a characteristic diameter of the opening at the interface.
4. The apparatus of clause 1 or clause 2, wherein a ratio of a characteristic diameter of the well at an interface between the well structure and the dielectric structure relative to a characteristic diameter of the opening at the interface is in a range of 1.01 to 2.
5. The apparatus of clause 4, wherein the ratio is in a range of 1.01 to 1.5.
6. The apparatus of clause 5, wherein the ratio is in a range of 1.01 to 1.15.
7. The apparatus of any one of clauses 1-6, wherein the well structure comprises an oxide of silicon or a nitride of silicon.
8. The apparatus of any one of clauses 1-7, wherein the well structure comprises a layer of an oxide of silicon and a layer of a nitride of silicon.
9. The apparatus of any one of clauses 1-8, wherein the conductive layer extends along the wall of the well to an interface between the well structure and the dielectric structure.
10. The apparatus of any one of clauses 1-9, wherein the conductive layer comprises a metal.
11. The apparatus of clause 10, wherein the metal is selected from the group consisting of aluminum, copper, nickel, titanium, silver, gold, platinum, hafnium, lanthanum, tantalum, tungsten, iridium, zirconium, palladium, and a combination thereof.
12. The apparatus of any one of clauses 1-11, wherein the conductive layer comprises a conductive ceramic material.
13. The apparatus of clause 11, wherein the conductive ceramic material is selected from the group consisting of titanium nitride, titanium aluminum nitride, titanium oxynitride, tantalum nitride, and a combination thereof.
14. The apparatus of any one of clauses 1-13, wherein the dielectric structure is thicker than the well structure.
15. The apparatus of any one of clauses 1-14, wherein a ratio of the thickness of the dielectric layer to the thickness of the well structure is in a range of 1.01 to 10.
16. The apparatus of clause 15, wherein the range is 1.05 to 3.
17. The apparatus of clause 16, wherein the range is 1.05 to 2.
18. The apparatus of any one of clauses 1-17, wherein the dielectric layer comprises a low temperature oxide of silicon.
19. The apparatus of any one of clauses 1-18, wherein the gate structure is a floating gate structure.
20. The apparatus of any one of clauses 1-19, wherein the gate structure includes a barrier layer at the upper surface and in contact with the conductive layer.
21. A method of forming a sensor device, the method comprising:
   forming a well structure over a substrate, a gate structure disposed on the substrate and having an upper surface;
   forming a well in the well structure to expose the upper surface of the gate structure, the well including a well wall, the well structure defining an interstitial surface between wells;
   depositing conformally a conductive material over the well structure;
   removing the conductive material from the interstitial surface;
   forming a dielectric layer over the well structure; and
   forming an opening in the dielectric layer, the opening extending to the well.
22. The method of clause 21, wherein forming the dielectric layer over the well structure comprises depositing a fill material into the well and depositing the dielectric layer over the well structure and the fill material in the well.
23. The method of clause 22, wherein depositing the fill material into the well includes depositing the fill material over the well structure, the fill material entering the well, and removing excess fill material from over the well structure.
24. The method of clause 23, wherein removing the excess fill material includes performing chemical mechanical polishing of the fill material.
25. The method of clause 24, wherein performing chemical mechanical polishing is stopped when the conductive material is detected.
26. The method of clause 23, wherein removing the excess fill material includes etching the fill material.
27. The method of clause 26, wherein etching includes etching until the material of the well structure is detected.
28. The method of any one of clauses 21-27, wherein a characteristic diameter of the well at an interface between the well structure and the dielectric structure is greater than a characteristic diameter of the opening at the interface.
29. The method of any one of clauses 21-27, wherein a characteristic diameter of the well at an interface between the well structure and the dielectric structure is approximately a characteristic diameter of the opening at the interface.
30. The method of any one of clauses 21-27, wherein a ratio of a characteristic diameter of the well at an interface between the well structure and the dielectric structure relative to a characteristic diameter of the opening at the interface is in a range of 1.01 to 2.
31. The method of any one of clauses 21-30, wherein the well structure comprises an oxide of silicon or a nitride of silicon.
32. The method of any one of clauses 21-31, wherein the well structure comprises a layer of an oxide of silicon and a layer of a nitride of silicon.
33. The method of any one of clauses 21-32, wherein the conductive layer extends along the wall of the well to an interface between the well structure and the dielectric structure.
34. The method of any one of clauses 21-33, wherein the conductive layer comprises a metal selected from the group consisting of aluminum, copper, nickel, titanium, silver, gold, platinum, hafnium, lanthanum, tantalum, tungsten, iridium, zirconium, palladium, and a combination thereof.
35. The method of any one of clauses 21-34, wherein the conductive layer comprises a conductive ceramic material selected from the group consisting of titanium nitride, titanium aluminum nitride, titanium oxynitride, tantalum nitride, and a combination thereof.
36. The method of any one of clauses 21-35, wherein the dielectric structure is thicker than the well structure.
37. The method of any one of clauses 21-36, wherein a ratio of the thickness of the dielectric layer to the thickness of the well structure is in a range of 1.01 to 10.
38. The method of any one of clauses 21-37, wherein the dielectric layer comprises a low temperature oxide of silicon.
39. The method of any one of clauses 21-38, wherein the gate structure is a floating gate structure.
40. The method of any one of clauses 21-39, wherein the gate structure includes a barrier layer at the upper surface and in contact with the conductive layer.

## Claims

1. A semiconductor device comprising:
an array of sensors, each sensor having a floating gate disposed over a substrate; said floating gate including a top sensor plate with an upper surface,
an array of wells disposed over the array of sensors; each well being disposed over the upper surface of a corresponding top sensor plate;
a conductive layer disposed on the upper surface of each top sensor plate which at least partially extends along a wall of the well; and
a dielectric layer disposed over the array of wells, wherein a characteristic diameter of an opening to each well formed through the dielectric layer is approximately the same as a characteristic diameter of an opening at an interface between each well and the dielectric layer.

2. The device of claim 1, wherein the array of wells is formed in a combination of dielectric layers.

3. The device of claim 2, wherein the dielectric layer disposed over the array of wells is thicker than the combination of dielectric layers in which the array of wells is formed.

4. The device of claim 3, wherein a ratio of a thickness of the dielectric layer over the array of wells to a thickness of the combination of dielectric layers in which the array of wells is formed is in a range of 1.01 to 10.

5. The device of claim 4, wherein the range is 1.05 to 3.

6. The device of claim 1, wherein the dielectric layer disposed over the array of wells comprises an oxide of silicon.

7. The device of claim 2, wherein the combination of dielectric layers in which the array of wells is formed comprises a layer of an oxide of silicon and a layer of a nitride of silicon.

8. The device of claim 7, wherein the combination of dielectric layers in which the array of wells is formed further comprises a layer of an oxide of silicon formed on the layer of the nitride of silicon.

9. The device of claim 1, wherein the conductive layer extends in a range between 20% to 100% along the wall of the well.

10. The device of claim 1, wherein the upper surface of the top sensor plate is titanium nitride.

11. The device of claim 1, wherein the conductive layer comprises a metal layer.

12. The device of claim 11, wherein the metal is selected from the group consisting of aluminum, copper, nickel, titanium, silver, gold, platinum, hafnium, lanthanum, tantalum, tungsten, iridium, zirconium, palladium, and a combination thereof.

13. The device of claim 12, wherein an upper surface of the conductive layer comprises a thin oxide of the metal layer.

14. The device of claim 13, wherein the upper surface of the conductive layer is a sensing surface.

15. The device of claim 14, wherein the upper surface of the conductive layer is an ion-sensitive sensing surface.
